# EUROPÄISCHE PATENTSCHRIFT

(11) **EP 2 332 250 B1**
(45) Veröffentlichungstag und Bekanntmachung des Hinweises auf die Patenterteilung: **30.07.2014**
(21) Anmeldenummer: 09782363.7
(22) Anmeldetag: 28.08.2009
(51) Int. Cl.: H03D 9/06

(54) **VERTEILTER RESISTIVER MISCHER**
DISTRIBUTED RESISTIVE MIXER
MÉLANGEUR RÉSISTIF RÉPARTI

(30) Priorität: 12.09.2008 DE 102008047101
(43) Veröffentlichungstag der Anmeldung: 15.06.2011
(73) Patentinhaber: Johann Wolfgang Goethe-Universität, Frankfurt am Main, 60323 Frankfurt am Main (DE); Bergische Universität Wuppertal, 42119 Wuppertal (DE)
(72) Erfinder: PFEIFFER, Ullrich, 42349 Wuppertal (DE); OEJEFORS, Erik, 42119 Wuppertal (DE); ROSKOS, Hartmut G., 61476 Kronberg (DE); LISAUSKAS, Alvydas, 60435 Frankfurt am Main (DE)
(74) Vertreter: WSL Patentanwälte Partnerschaft mbB
(86) Internationale Anmeldenummer: PCT/EP2009/061169
(87) Internationale Veröffentlichungsnummer: WO 2010/028966

(56) Entgegenhaltungen:
- FR-A- 2 597 680
- US-A- 4 675 911
- US-A- 5 136 720

## Beschreibung

Die vorliegende Erfindung betrifft einen resistiven Mischer zum Mischen oder Erfassen eines elektrischen bzw. elektromagnetischen Hochfrequenzsignals.

Der Terahertzfrequenzbereich oder Submillimeterwellenlängenbereich, der grob von 100 Gigahertz (GHz) bis 10 Terahertz (THz) definiert ist, ist einer der letzten "dunklen" Bereiche des elektromagnetischen Spektrums. Technische nutzbare, insbesondere kohärente Quellen und entsprechende Detektoren, sind in diesem Frequenzbereich bisher nicht oder nur bei niedrigen Frequenzen kommerziell erhältlich. Die Entwicklungen der letzten Jahrzehnte haben zu Systemen geführt, die aufgrund ihrer Komplexität bisher jedoch nur in experimentell geprägten Gebieten, wie der Radioastronomie oder der Atmosphärenforschung, Anwendung finden. Für Anwendungen des täglichen Lebens fehlt es bisher an der Verfügbarkeit preiswerter Quellen und Detektoren und dies, obwohl der THz-Frequenzbereich gegenüber anderen Frequenzbändern des elektromagnetischen Spektrums intrinsische Vorteile aufweist:
- Viele optisch undurchsichtige Materialien sind im THz-Frequenzbereich transparent.
- THz-Strahlung ist nichtionisierend und wird daher im biomedizinischen Bereich als sicher betrachtet.
- Bestimmte rotatorische, vibronische oder libratorische Molekülanregungen weisen eine Resonanzfrequenz im THz-Frequenzbereich auf.
- THz-Strahlung liefert wesentliche Informationen über Ladungsträgerdynamiken, insbesondere in Nanostrukturen, die eine essentielle Rolle in zukünftigen photonischen und elektronischen Komponenten spielen.
- THz-Strahlung zeigt eine geringere Streuung verglichen mit optischen Frequenzen und ist daher insbesondere zur Verwendung in industriellen Umgebungen, in denen es beispielsweise vermehrt zu Staubbildung kommt, geeignet.
- Betrachtet man Kommunikationssysteme, so ermöglichen höhere Frequenzen größere Übertragungsbandbreiten.

Die meisten rein elektronischen Vorrichtungen, die im THz-Frequenzbereich arbeiten, basieren auf GaAs- oder InP-Halbleitertechnologie. Zuletzt wurde gezeigt, dass auch SiGe- und CMOS-Halbleitertechnologien zu Vorrichtungen führen, die bei Frequenzen bis zu 100 GHz arbeiten. Bei höheren Frequenzen bis hin zu 1 THz und darüber hinaus werden komplexere Quantenkaskadenlasersyteme ebenso als Quellen verwendet wie optoelektronische Systeme, basierend auf Femtosekundenkurzpulslasem oder dem Mischen zweier Dauerstrichlaserquellen.

THz-Strahlung wird in den bekannten Systemen zur Zeit mit Heterodynmischem, zum Beispiel Schottky-Diodenmnischem, photokonduktiven Detektoren oder Leistungsdetektoren, wie zum Beispiel photovoltaischen Detektoren, Bolometem oder Golay-Zellen, erfasst.

Alle zuvor beschriebenen Techniken weisen jedoch eine erhebliche Komplexität der Quellen- und Detektorbauelemente selbst sowie bei deren Herstellung auf, so dass diese zwar im Bereich der Forschung und Entwicklung sowie in forschungsnahen Anwendungsgebieten, wie der Radioastronomie, Verwendung finden, jedoch nicht für Massenmärkte geeignet sind.

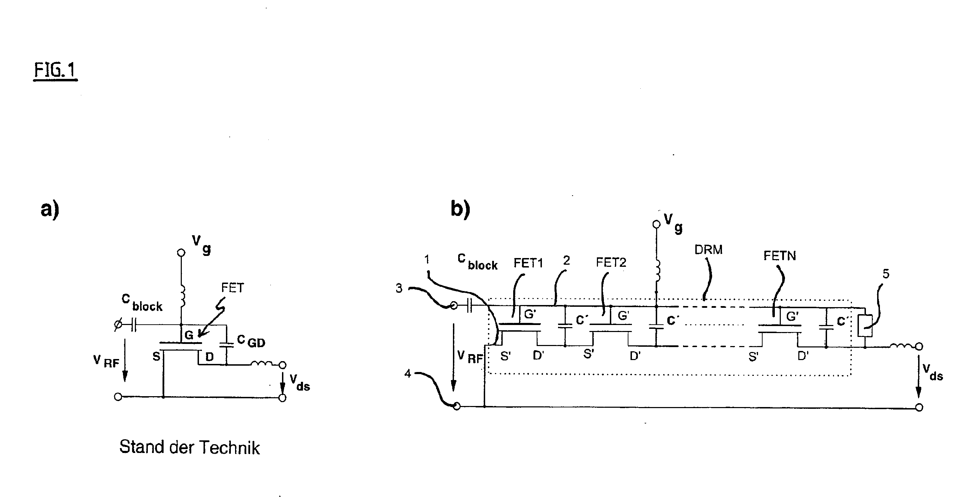

Aus der US 4,647,848 ist ein Feldeffekttransistor bekannt, welcher als diskreter resistiver Mischer betrieben wird. Der Feldeffekttransistor wird verwendet, um die Leistung eines elektromagnetischen Hochfrequenzsignals V_{RF} zu erfassen. Ein Detektorschaltkreis aus dem Stand der Technik ist in Figur 1a) dieser Anmeldung gezeigt. Das Hochfrequenzsignal wird in das Gate G und über eine Kapazität C_{GD} in den Drain D des Feldeffekttransistors FET eingekoppelt, wobei das Gate G mit einer Gleichspannung V_{g} vorgespannt ist, welche dem Schwellenwert des Transistors FET entspricht. Der resultierende Strom an der Source S enthält dann einen Gteichstromanteil I_{ds}, der proportional zum Quadrat der Amplitude des Hochfrequenzsignals ist. Über einen entsprechenden externen Widerstand kann das Ausgangssignal als Spannung V_{ds} erfasst werden. Dabei ist der beschriebene Empfängerschaltkreis aus diskreten Bauelementen aufgebaut. Das Ausgangssignal wird mit einem Tiefpassfilter gefiltert, um die Wechselstromantelle zu unterdrücken.

Dabei ist die Betriebsfrequenz des in US 4,647,848 beschriebenen Leistungsdetektors durch die diskrete Anordnung und insbesondere durch die vorgegebene Gatelänge des Feldeffekttransistors auf wenige Gigahertz (GHz) beschränkt.

Aus US 5,136,720 ist ein Matrixmischer, der einen Verstärker mit einer Mehrzahl aufeinanderfolgend gekoppelter Transistoren aufweist, bekannt. In einem Mischzustand ist dabei eine Mehrzahl von Mischerelementen aufeinanderfolgend über eine gemeinsame Übertragungsleitung mit dem Ausgang der Mehrzahl von Transistoren des Verstärkers verbunden.

US 4,675,911 beschreibt eine Breitband-Verstärker-Vorrichtung in der eine Mehrzahl von Verstärkern verteilt angeordnet sind. Die Breitband-Verstärker-Vorrichtung weist einen Signalteiler auf, der ein Signal eines lokalen Oszillators empfängt, aufteilt und mit derselben Phase an Eingangspole einer Übertragungsleitung weiterleitet. Die Übertragungsleitung weist außerhalb der Platine angeordnete Induktivitäten und Shunt-Kapazitäten der verteilten Breitbandgegenphasenverstärker auf. Eine solche Anordnung ist auf Frequenzen deutlich unter dem Terahertzfrequenzbereich begrenzt.

Gegenstand von FR 2 597 680 A1 ist ein Halbleiterelement das einen Schaltkreis mit verteilten Mischem/Verstärkern einschließt. Der Schaltkreis besteht dabei aus einer Mehrzahl von Feldeffekttransistoren, deren erste und zweite Gates mit einer Spule verbunden sind und so eine Übertragungsleitung bilden. Als beispielhafter Frequenzbereich werden Frequenzen von bis zu 20 GHz genannt.

Demgegenüber liegt der vorliegenden Erfindung die Aufgabe zugrunde, einen resistiven Mischer bereitzustellen, welcher bei hohen Gigahertz- und Terahertzfrequenzen arbeitet.

Diese Aufgabe wird erfindungsgemäß durch einen resistiven Mischer gelöst mit einer Leitung, die einen ersten und einen zweiten elektrischen Leiter mit je einem Anschlusskontakt aufweist, so dass ein elektrisches Hochfrequenzsignal in die Leitung einkoppelbar ist, wobei der erste Leiter eine Mehrzahl von in Reihe geschalteten spannungsabhängigen Widerstandselementen (R) aufweist, und wobei zwischen dem ersten und dem zweiten Leiter mindestens ein kapazitives Element (C) angeordnet ist.

Unter resistiven Mischern im Sinne der vorliegenden Anmeldung werden sowohl klassische resistive Mischer, bei denen die Modulierung des Kanalwiderstandes im quasistationären Grenzfall erfolgt, als auch plasmonische resistive Mischer verstanden, bei denen kollektive Ladungsträgerschwingungen (Plasmonen) im 2-dimensionalen Elektronengas angeregt werden. Die Plasmonen können schwach gedämpft oder überdämpft sein.

Unter einem elektrischen Leiter im Sinne der vorliegenden Erfindung wird eine elektrische Verbindung verstanden, welche den elektrischen Strom permanent, zeitweilig oder unter bestimmten Umgebungsbedingungen leitet. Darunter fallen nicht nur klassische Leiter, wie z. B. Kupfer oder andere Metalle, sondern insbesondere auch Halbleiter. Gemäß der Erfindung können die Leiter vorzugsweise Kombinationen von metallisch leitfähigen Abschnitten und Halbleiterabschnitten aufweisen.

Die von den ersten und zweiten Leitern gebildete Leitung ist eine Hochfrequenzleitung, auch als Übertragungsleitung oder englisch Transmission Line bezeichnet.

Auf diese Weise wird erfindungsgemäß eine RC-Leitung mit verteilten spannungsabhängigen Widerständen und Kapazitäten bereitgestellt. Der resistive Mischer gemäß der vorliegenden Erfindung besteht aus einer Abfolge von in Reihe geschalteten elementaren spannungsabhängigen Widerstandselementen und parallel geschalteten Kapazitäten, die durch ihre verteilte Anordnung ein auf die Leitung eingekoppeltes Hochfrequenzsignal jeweils lokal resistiv mischen und jeweils bereits lokal einen Gleichstrom erzeugen, welcher abhängig von der Leistung des Hochfrequenzsignals ist. Innerhalb des verteilten resistiven Mischers erreichen die elementaren spannungsabhängigen Widerstandselemente weit bessere Hochfrequenzeigenschaften als beispielsweise der aus dem Stand der Technik bekannte zum resistiven Mischen verwendete einzelne Feldeffekttransistor, dessen Gatelänge aufgrund der Beschränkung der zur Verfügung stehenden Prozesstechnologien nicht beliebig verringert werden kann.

In einer Ausführungsform ist jeweils zwischen einem ersten und einem zweiten spannungsabhängigen Widerstandselement ein kapazitives Element zwischen der ersten und der zweiten Leitung zum Bereitstellen der vollständigen RC-Leitung angeordnet.

In einer bevorzugten Ausführungsform der Erfindung sind die spannungsabhängigen Widerstandselemente und das kapazitive Element in einem einzigen Halbleiterbauelement auf einem einzigen Substrat integriert. Auf diese Weise lassen sich nicht nur reduzierte Abmessungen, insbesondere Gatelängen der spannungsabhängigen Widerstandselemente realisieren, sondern auch parasitäre Kapazitäten, wie sie in Anordnungen mit diskreten Bauelementen auftreten, vermeiden bzw. auf die Randbereiche der Leitung reduzieren.

Unter einem spannungsabhängigen Widerstandselement im Sinne der vorliegenden Erfindung wird ein elektrischer Widerstand verstanden, dessen Wert von der lokal am Widerstand anliegenden Spannung abhängt. In einer bevorzugten Ausführungsform der Erfindung ist ein solches spannungsabhängiges Widerstandselement ein Feldeffekttransistor, wobei es für die Funktionsweise des Elements nicht darauf ankommt, mit welcher Halbleitertechnologie die serielle Anordnung der Feldeffekttransistoren realisiert ist. Beispiele für solche Realisierungen sind die Siliziumtechnologie, CMOS-Technologie, etc.

In einer Ausführungsform der Erfindung, bei welcher die spannungsabhängigen Widerstandselemente Feldeffekttransistoren mit jeweils einer Source, einem Drain, einem Gate und einem Source-Drain-Kanal sind, sind die Gates aller Feldeffekttransistoren so elektrisch miteinander verbunden, dass die Gates den zweiten Leiter der Leitung bilden, und wobei der Drain eines ersten Feldeffekttransistors mit der Source eines zweiten Feldeffekttransistors verbunden ist, so dass die Source, der Source-Drain-Kanal und der Drain des ersten Feldeffekttransistors und die Source, der Source-Drain-Kanal und der Drain des zweiten Feldeffekttransistors den ersten Leiter bilden.

In einer bevorzugten Ausführungsform der Erfindung sind die einzelnen elementaren Feldeffekttransistoren, die als spannungsabhängige Widerstandselemente in Reihe geschaltet sind, durch die Strukturierung eines gemeinsamen Gates bzw. eines gemeinsamen Source-Drain-Kanals realisiert.

In einer solchen Ausführungsform wird, anschaulich beschrieben, ein diskreter Feldeffekttransistor, so wie er z.B. als JFET aus dem Stand der Technik bekannt ist und dessen effektive Gatelänge vom Abstand zwischen Source und Drain bestimmt ist, durch eine entsprechende Strukturierung der metallischen Struktur oder der Oxidschicht des Gates oder eine Halbleiterstrukturierung des Source-Drain-Kanals in eine Anordnung miteinander verbundener elementarer Feldeffekttransistoren gegliedert. Jeder einzelne dieser elementaren Feldeffekttransistoren weist innerhalb der Anordnung eine gegenüber der Gatelänge des ursprünglichen diskreten, nicht aufgeteilten Feldeffekttransistors deutlich verringerte effektive Gatelänge auf.

Im Falle der Strukturierung des Gates ist vorzugsweise die Metallisierung des Gates in Form einer sich periodisch widerholenden Struktur ausgestaltet. Diese Struktur hat in einer Ausführungsform die Form eines Gitters.

Unter einer Halbleiterstrukturierung im Sinne der vorliegenden Erfindung wird eine räumliche Strukturierung, insbesondere ein räumlich variierendes Dotierprofil verstanden. Eine solche Strukturierung des Dotierprofils hat in einer Ausführungsform die Form einer periodisch modulierten Dotierung des Source-Drain-Kanals in vertikaler oder longitudinaler Richtung.

Bei einem herkömmlichen Feldeffekttransistor können die Source und der Drain aufgrund der Beschränkungen in der Prozesstechnologie nicht beliebig nah aneinander herangeführt werden, so dass der Source-Drain-Abstand eines diskreten Feldeffekttransistors 250 nm nicht unterschreiten kann. Dieser Source-Drain-Abstand beschränkt darüber hinaus auch die mögliche Reduzierung der effektiven Gatelänge eines herkömmlichen Feldeffekttransistors.

Demgegenüber ist es bei der erfindungsgemäßen Anordnung möglich, insbesondere das Gate mit einer Auflösung zu strukturieren, welche deutlich unter 250 nm liegt, so dass die einzelnen durch die Strukturierung des Gates gebildeten elementaren Feldeffekttransistoren weit geringere effektive Gatelängen aufweisen als die Gesamtanordnung. Strukturiert man beispielsweise das Gate eines Feldeffekttransistors mit einer Gatelänge von 250 nm so, dass zehn elementare Feldeffekttransistoren gemäß der vorliegenden Erfindung ausgebildet werden, so weist jeder der elementaren Feldeffekttransistoren nur eine effektive Gatelänge von weniger als 25 nm auf.

In einer Ausführungsform der Erfindung weist jeder der elementaren Feldeffekttransistoren eine effektive Gatelänge bzw. eine Länge des Source-Drain-Kanals von weniger als 250 nm, vorzugsweise von weniger als 200 nm auf.

In einer Ausführungsform der erfindungsgemäßen Anordnung, bei welcher die Reihenschaltung der elementaren Feldeffekttransistoren durch eine Gliederung des Source-Drain-Kanals eines herkömmlichen, diskreten Feldeffekttransistors entweder durch die Strukturierung des Gates (Strukturierung der metallischen Struktur und/oder der Oxidschicht) oder des Source-Drain-Kanals erzielt wird, weisen die realisierten elementaren Feldeffekttransistoren keine eindeutig voneinander zu trennende Source und Drain auf. Diese sind vielmehr als Bereiche des Source-Drain-Kanals des Gesamtbauselement, die durch ihre Funktion definiert sind, ausgebildet. Insbesondere bildet beispielsweise ein Bereich des Source-Drain-Kanals des Gesamtbauelements, welcher den Drain eines ersten elementaren Feldeffekttransistors definiert, gleichzeitig auch die Source eines zweiten Feldeffekttransistors.

Zweckmäßig ist es dabei, wenn das kapazitive Element bzw. die Mehrzahl von kapazitiven Elementen der RC-Leitung ebenfalls durch eine entsprechende Strukturierung des Gates oder des gemeinsamen Source-Drain-Kanals realisiert ist. Auf diese Weise wird durch die Strukturierung nicht nur die Realisierung der verteilten Feldeffekttransistoren in der Gesamtanordnung realisiert, sondern auch die Parallelschaltung der erforderlichen Kapazitäten.

In einer weiteren Ausführungsform der Erfindung wird durch eine Strukturierung des Gates oder des gemeinsamen Source-Drain-Kanals statt einer diskreten Anordnung von in Reihe geschalteten verteilten spannungsabhängigen Widerstandselementen eine Reihe von ineinander übergehenden Anordnungen geschaffen. Dies stellt den Grenzfall einer Anordnung mit einer sehr großen Anzahl von Transistoren (N geht gegen unendlich) dar, wobei die effektive Gatelänge der einzelnen Transistoren sehr klein wird und gegen null geht. Insbesondere kann eine solche Anordnung dadurch erreicht werden, dass der Source-Drain-Kanal der Gesamtanordnung mit einem rampenförmigen Dotierprofil versehen wird, wobei die Dotierung des Source-Drain-Kanals zwischen der Source und dem Drain kontinuierlich ab- oder zunimmt.

Dabei ergeben sich im Grenzfall einer weiteren Ausführungsform der vorliegenden Erfindung Kapazitätsbeläge und spannungsabhängige Widerstandsbeläge, wie sie sich auch innerhalb eines elektrisch langen FET-Kanals ausbilden. Dieser Grenzfall führt zur Erzeugung von Plasmaschwingungen eines zweidimensionalen Elektronengases und somit einer Überhöhung des Mischereffekts.

Dabei ist es zweckmäßig, wenn die zweite Leitung zum Vorspannen der Gates der Feldeffekttransistoren mit einer Gleichspannungsquelle verbunden ist. Auf diese Weise können im Betrieb die Gates der verteilten Feldeffekttransistoren mit einer Gleichspannung derart vorgespannt werden, dass der Schwellenwert der Transistoren erreicht wird.

Da eine solche Vorspannung der Gates jedoch insbesondere bei Feldeffekttransistoren mit dünnen Gateoxiden Leckströme hervorruft, sind in einer alternativen Ausführungsform die Feldeffekttransistoren Feldeffekttransistoren mit einer vernachlässigbar kleinen Schwellenspannung, d.h. sogenannte Zero-V_{T}-FETs. Auf diese Weise lassen sich Leckströme auch bei sehr dünnen Gateoxidschichten reduzieren und das Signal-Rausch-Verhältnis der Vorrichtungen verbessern. Durch die Reduzierung der Dicke der Gateoxidschichten wird die spektrale Empfindlichkeit und Bandbreite des Bauelementes weiter verbessert.

In einer Ausführungsform der Erfindung sind der erste und der zweite Leiter an ihrer den Anschlusskontakten gegenüberliegenden Enden mit einem externen Anpassungsnetzwerk verbunden, um die Empfindlichkeit der Anordnung zu erhöhen. Das externe Netzwerk ermöglicht eine Phasenanpassung zwischen der Gatespannung und einer zusätzlich eingekoppelten externen RF-Drainspannung.

In einer weiteren Ausführungsform der Erfindung sind auf der Leitung zusätzlich zu dem Widerstandselementen und den kapazitiven Elementen eine oder mehrere Dioden oder andere nichtlineare Bauelemente vorgesehen, um die Mischereffizienz weiter zu erhöhen. Dabei kann die Diode entweder in Reihe zu den spannungsabhängigen Widerstandselementen auf dem ersten Leiter vorgesehen sein oder parallel zu dem kapazitiven Element zwischen erstem und zweitem Leiter vorgesehen sein.

Das resistive Mischerelement gemäß der vorliegenden Erfindung weist einen breiten Einsatzbereich auf. Insbesondere lässt sich das resistive Mischerelement als Detektor für elektromagnetische Hochfrequenzstrahlung im THz-Frequenzbereich einsetzen. In einer solchen Ausführungsform ist es zweckmäßig, wenn die Leitung mit einem Antennenelement für Hochfrequenzstrahlung verbunden ist, so dass im Betrieb des Detektors von der Antenne empfangene elektromagnetische Hochfrequenzstrahlung in die Leitung einspeisbar ist.

Um die Leistung der auf das Antennenelement auftreffenden Hochfrequenzstrahlung zu erfassen, ist es vorteilhaft, wenn der Ausgang der Leitung mit einem Charge Coupled Device (CCD) verbunden ist. Dieses Charge Coupled Device (CCD) integriert den Gleichstromausgang des Mischers und das integrierte Signal wird über eine entsprechende Ausleseelektronik erfasst.

In einer weiteren Ausführungsform mit einer zeilen- oder matrixförmigen Anordnung von Detektorelementen (Kamera, Focal-Plane) wird das Charge Coupled Device (CCD) sequentiell ausgelesen und nach einer Integrationszeit gelöscht.

In einer alternativen Ausführungsform wird der erfindungsgemäße resistive Mischer als Mischer zum Mischen eines Hochfrequenzsignals im THz-Frequenzbereich mit einem elektrischen Lokaloszillatorsignal eingesetzt. Dazu ist eine Ausführungsform des Detektors zweckmäßig, bei welcher der zweite Leiter des Mischers in einer der zuvor beschriebenen Ausführungsformen mit einer Lokaloszillatorquelle verbunden ist.

Weitere Vorteile, Merkmale und Anwendungsmöglichkeiten der vorliegenden Erfindung werden anhand der vorliegenden Beschreibung und der dazugehörigen Figuren deutlich.
- Figur 1 a): zeigt einen resistiven Mischer gemäß dem Stand der Technik,
- Figur 1b): zeigt das Ersatzschaltbild eines resistiven Mischers gemäß einer Ausführungsform der Erfindung.
- Figur 2: zeigt schematisch den Aufbau einer weiteren Ausführungsform des resistiven Mischers gemäß einer Ausführungsform der Erfindung.
- Figuren 3A) und B): zeigen die Realisierung eines Spannungs- (A) bzw. Stromausgangs (B) am Drain eines Mischers gemäß einer Ausführungsform der Erfindung.
- Figur 4: zeigt einen Leistungsdetektor für elektromagnetische Hochfrequenzstrahlung mit einem resistiven Mischer gemäß einer Ausführungsform der Erfindung.
- Figur 5: zeigt einen Detektor zur Erfassung von Leistung und Phase von elektromagnetischer Hochfrequenzstrahlung mit einem resistiven Mischer gemäß einer Ausführungsform der Erfindung.

In den nachfolgend beschriebenen Figuren tragen identische Elemente bzw. Elemente, welche eine analoge Funktion erfüllen, gleiche Bezugszeichen.

In Figur 1a) ist ein resistiver Mischer dargestellt, so wie er aus dem Stand der Technik bekannt ist. Er wurde bereits in der Beschreibungseinleitung beschrieben.

Figur 1b) zeigt ein Ersatzschaltbild, welches schematisch den Aufbau einer Ausführungsform des erfindungsgemäßen resistiven Mischers darstellt. In der dargestellten Ausführungsform des Mischers sind die elementaren spannungsabhängigen Widerstandselemente durch eine Reihe von Feldeffekttransistoren FET1, FET2, ... FETN realisiert, wobei die beispielhaft dargestellten drei Transistoren für eine große Anzahl von Transistoren, beispielsweise 20, stehen. Jeder der Feldeffekttransistoren FET weist eine Source S, einen Drain D sowie ein Gate G auf. In der dargestellten Ausführungsform sind die Feldeffekttransistoren als Junction-Feldeffekttransistoren (JFETs) realisiert. Die Feldeffekttransistoren sind in eine Hochfrequenzleitung mit einem ersten Leiter 1 und einem zweiten Leiter 2 integriert. Ein Hochfrequenzsignal V_{RF} kann über zwei Anschlüsse 3, 4 in die Hochfrequenzleitung mit den Leitern 1, 2 eingekoppelt werden. Der erste Leiter 1 der Hochfrequenzleitung wird von der Source S' des ersten Feldeffekttransistors FET1, dem Soure-Drain-Kanal des ersten Feldeffekttransistors FET1, dem Drain D' des ersten Feldeffekttransistors FET1, einer Verbindung zwischen dem Drain D' des ersten Feldeffekttransistors FET1 und der Source S' des zweiten Feldeffekttransistors FET2, der Source S' des zweiten Feldeffekttransistors FET2, dem Source-Drain-Kanal des zweiten Feldeffekttransistors FET2, dem Drain D' des zweiten Feldeffekttransistors FET2 usw. gebildet, bis er mit der Drain D' des letzten Feldeffekttransistors FETN endet.

Der zweite Leiter 2 hingegen verbindet die Gates G' der einzelnen Feldeffekttransistoren FET1, FET2, ... FETN bzw. wird von einer durchgehenden Struktur, welche die Gates der einzelnen Transistoren ausbildet, bereitgestellt. Zwischen dem ersten Leiter 1 und dem zweiten Leiter 2 sind parallel angeordnete Kapazitäten C' angeordnet. In der dargestellten Ausführungsform entspricht die Anzahl der Kapazitäten C' der Anzahl der Feldeffekttransistoren N. Der erste Leiter 1 und der zweite Leiter 2 sind über einen externen Anpassungsschaltkreis 5 am Ende der Leitung, d.h. am Drain des letzten Feldeffekttransistors FETN miteinander verbunden, um eine externe Phasenverschiebung einzustellen und somit die Empfindlichkeit der Anordnung erhöhen zu können.

Bei dem in Figur 1 b) dargestellten Mischer DRM (Distributed Resistive Mixer) handelt es sich um ein integriertes Bauelement, das auf einem einzigen Substrat realisiert ist.

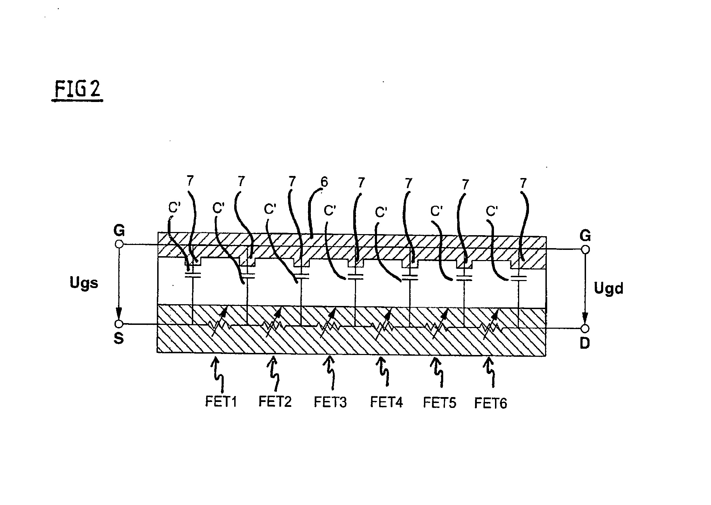

Eine solche integrierte Realisierung des verteilten resistiven Mischers DRM ist in Figur 2 schematisch dargestellt. Der Aufbau entspricht zunächst einem diskreten Feldeffekttransistor mit einem Gate G, einer Source S und einem Drain D mit einer Gatelänge von ca. 250 nm. Um mit diesem herkömmlichen Feldeffekttransistor eine RC-Hochfrequenzleitung mit einer Anordnung von in Serie geschalteten verteilten Feldeffekttransistoren zu realisieren, wird der Feldeffekttransistor durch Strukturierung des Gates G in einzelne elementare Transistoren FET1 bis FET6 "zerlegt". Dazu ist die Dicke des Gateoxids insgesamt verringert, weist jedoch verdickte Abschnitte 7 auf. Durch diese periodische Strukturierung werden zum einen elementare Feldeffekttransistoren FE1...FE6 in Reihe bereitgestellt, zum anderen bilden die Verdickungen der Oxidschicht 6 des Halbleiterelements die Kapazitäten C' aus. Eingezeichnet in die Halbleiterstruktur sind im Rahmen eines Ersatzschaltbildes diese Kapazitäten C' sowie die spannungsabhängigen Widerstände der einzelnen Feldeffekttransistoren FET1 bis FET6.

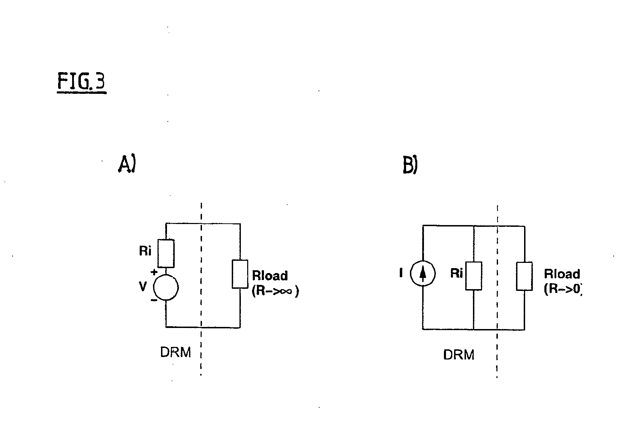

In Abhängigkeit vom Lastwiderstand, welcher mit dem zweiten Ende der Leitung verbunden wird, können Spannungs- bzw. Stromausgänge für das Auslesen des verteilten resistiven Mischers DRM bereitgestellt werden. Wird wie in Figur 3 gezeigt der Ausgang der Leitung mit einem hohen Lastwiderstand R_{load} verbunden, so kann ein Spannungsausgang am Drain des letzten Feldeffekttransistors (FETN aus Figur 1 b)) realisiert werden. Wird hingegen wie in Figur 3b) schematisch dargestellt, das Ende der Leitung mit einem kleinen Lastwiderstand R_{load} verbunden, so wird ein Stromausgang am Drain des letzten Feldeffekttransistors (FET N in Figur 1b)) realisiert.

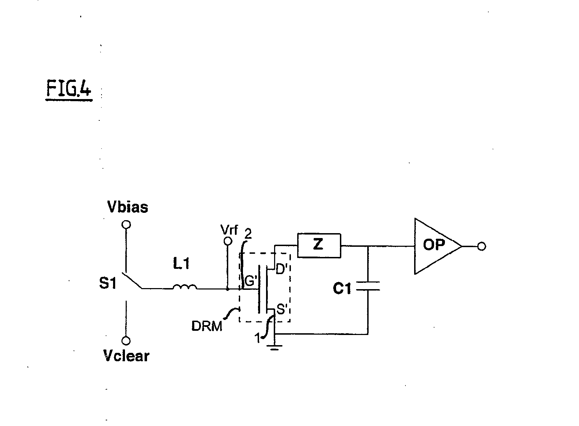

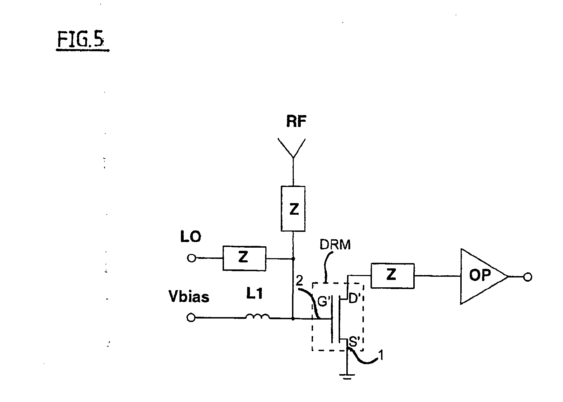

Figuren 4 und 5 zeigen die Verwendung eines erfindungsgemäßen verteilten resistiven Mischers DRM zum Erfassen der Leistung eines elektromagnetischen Hochfrequenzsignals im THz-Frequenzbereich bzw. zum Mischen des THz-Signals mit einem Lokaloszillatorsignal LO.

Figur 4 zeigt eine Anordnung, mit der sich die Leistung eines Hochfrequenzsignals Vrf, welches mit dem Leiter 2, d.h. den Gates G' des Mischers DRM verbunden ist, erfassen. Am Drain D' des letzten Feldeffekttransistors des Mischers DRM ist ein Filternetzwerk Z vorgesehen, welches eine Tiefpasscharakteristik aufweist, so dass nur die Gleichstromanteile von einem Charge Coupled Device C1 integriert und über eine Ausleseelektronik OP erfasst werden. Wie zuvor dargestellt, ist dieser Gleichstromanteil abhängig von der Leistung des in das Gate G' eingekoppelten Hochfrequenzsignals Vrf. Mit Hilfe eines Schalters S1 lässt sich die Vorspannung Vbias des Gates unterbrechen und durch eine Löschspannung ersetzen, so dass der Detektor nach Überschreiten der Integrationszeit auf null zurückgesetzt wird.

Figur 5 zeigt eine gegenüber der Ausführungsform aus Figur 4 erweiterte Detektoranordnung, bei der zusätzlich zu dem Hochfrequenzsignal RF (V_{rf} in Figur 4) ein Lokaloszillatorsignal, z. B. mit einer gegenüber dem Hochfrequenzsignal verringerten Frequenz , in die Gatestruktur G' des verteilten resistiven Mischers DRM eingekoppelt wird. Insbesondere kann das Lokaloszillatorsignal als elektromagnetische Welle, vorzugsweise über ein Antennenelement, in die Gatestruktur eingekoppelt werden.

Alternativ kann der Mischer auch zur Erfassung der Phasenlage einer dem Hochfrequenzsignal aufgeprägten Intensitätsmodulation verwendet werden. Dazu wird als Lokaloszillatorsignal das Modulationssignal, beispielsweise mit einer Frequenz von 100 MHz, bzw. ein phasenstarr an das Modulationssignal gekoppeltes Signal in die Gatestruktur G' eingekoppelt. Die Amplitude des mit der Auswerteelektronik OP erfassten Wechselstroms des verteilten resistiven Mischers DRM ist dann von der Phasenlage zwischen dem Lokaloszillatorsignal LO und dem Hochfrequenzsignal RF abhängig.

Für Zwecke der ursprünglichen Offenbarung wird darauf hingewiesen, dass sämtliche Merkmale, wie sie sich aus der vorliegenden Beschreibung, den Zeichnungen und den Ansprüchen für einen Fachmann erschließen, auch wenn sie konkret nur im Zusammenhang mit bestimmten weiteren Merkmalen beschrieben wurden, sowohl einzeln als auch in beliebigen Zusammenstellungen mit anderen der hier offenbarten Merkmale oder Merkmalsgruppen kombinierbar sind, soweit dies nicht ausdrücklich ausgeschlossen wurde oder technische Gegebenheiten derartige Kombinationen unmöglich oder sinnlos machen. Auf die umfassende, explizite Darstellung sämtlicher denkbarer Merkmalskombinationen wird hier nur der Kürze und der Lesbarkeit der Beschreibung wegen verzichtet.

Während die Erfindung im Detail in den Zeichnungen und der vorangehenden Beschreibung dargestellt und beschrieben wurde, erfolgt diese Darstellung und Beschreibung lediglich beispielhaft und ist nicht als Beschränkung des Schutzbereichs gedacht, so wie er durch die Ansprüche definiert wird. Die Erfindung ist nicht auf die offenbarten Ausführungsformen beschränkt.

Abwandlungen der offenbarten Ausführungsformen sind für den Fachmann aus den Zeichnungen, der Beschreibung und den beigefügten Ansprüchen offensichtlich. In den Ansprüchen schließt das Wort "aufweisen" nicht andere Elemente aus, und der unbestimmte Artikel "eine" oder "ein" schließt eine Mehrzahl nicht aus. Die bloße Tatsache, dass bestimmte Merkmale in unterschiedlichen Ansprüchen beansprucht sind, schließt ihre Kombination nicht aus. Bezugszeichen in den Ansprüchen sind nicht als Beschränkung des Schutzbereichs gedacht.

## Patentansprüche

1. Resistiver Mischer mit
einer Leitung, die einen ersten (1) und einen zweiten (2) elektrischen Leiter mit je einem Anschlusskontakt (3, 4) aufweist, so dass ein elektrisches Hochfrequenzsignal in die Leitung einkoppelbar ist,
**dadurch gekennzeichnet, dass** der erste Leiter (1) eine Mehrzahl von in Reihe geschalteten spannungsabhängigen Widerstandselementen (FET1, FET2, ..., FETN) aufweist, und
wobei zwischen dem ersten (1) und dem zweiten (2) Leiter mindestens ein kapazitives Element (C') angeordnet ist.

2. Resistiver Mischer nach Anspruch 1, **dadurch gekennzeichnet, dass** das kapazitive Element zwischen einem ersten und einem zweiten spannungsabhängigen Widerstandselement angeordnet ist.

3. Resistiver Mischer nach Anspruch 1 oder 2, **dadurch gekennzeichnet, dass** die spannungsabhängigen Widerstandselemente und das kapazitive Element in einem einzigen Halbeiterbauelement auf einem einzigen Substrat integriert sind.

4. Resistiver Mischer nach einem der Ansprüche 1 bis 3, **dadurch gekennzeichnet, dass** die spannungsabhängigen Widerstandselemente Feldeffekttransistoren mit jeweils einer Source (S), einem Drain (D), einem Gate (G) und einem Source-Drain-Kanal sind,
wobei die Gates aller Feldeffekttransistoren so elektrisch miteinander verbunden sind, dass die Gates (G) den zweiten Leiter (2) bilden, und
wobei der Drain eines ersten Feldeffekttransistors mit der Source eines zweiten Feldeffekttransistors verbunden ist, so dass die Source, der Source-Drain-Kanal und der Drain des ersten Feldeffekttransistors und die Source, der Source-Drain-Kanal und der Drain des zweiten Feldeffekttransistors den ersten Leiter (1) bilden.

5. Resistiver Mischer nach einem der Ansprüche 1 bis 4, **dadurch gekennzeichnet, dass** die einzelnen Feldeffekttransistoren durch eine Strukturierung des Gates und/oder des Source-Drain-Kanals ausgebildet sind.

6. Resistiver Mischer nach einem der Ansprüche 1 bis 5, **dadurch gekennzeichnet, dass** das kapazitive Element durch eine Strukturierung des Gates und/oder des Source-Drain-Kanals ausgebildet ist.

7. Resistiver Mischer nach einem der Ansprüche 1 bis 6, **dadurch gekennzeichnet, dass** jeder der Feldeffekttransistoren eine effektive Gatelänge von weniger als 250 nm, vorzugsweise von weniger als 200 nm aufweist.

8. Resistiver Mischer nach einem der Ansprüche 1 bis 7, **dadurch gekennzeichnet, dass** der zweite Leiter (2) mit einer Gleichspannungsquelle zum Vorspannen der Gates der Feldeffekttransistoren verbunden ist.

9. Resistiver Mischer nach einem der Ansprüche 1 bis 8, **dadurch gekennzeichnet, dass** die Feldeffekttransistoren vernachlässigbar kleine Schwellenspannungen aufweisen.

10. Resistiver Mischer nach einem der Ansprüche 1 bis 9, **dadurch gekennzeichnet, dass** der erste (1) und der zweite (2) Leiter an ihrem den Anschlusskontakten (3, 4) gegenüberliegenden Enden mit einem externen Anpassungsnetzwerk verbunden sind.

11. Resistiver Mischer nach einem der Ansprüche 1 bis 11, **dadurch gekennzeichnet, dass** die Leitung mindestens ein weiteres nichtlineares Bauelement, vorzugsweise eine Diode, aufweist.

12. Detektor zum Erfassen von elektromagnetischer Hochfrequenzstrahlung mit einem resistiven Mischer nach einem der Ansprüche 1 bis 11.

13. Detektor nach Anspruch 12, **dadurch gekennzeichnet, dass** die Leitung mit einem Antennenelement für Hochfrequenzstrahlung verbunden ist, so dass im Betrieb des Detektors von der Antenne empfangene elektromagnetische Hochfrequenzstrahlung in die Leitung einspeisbar ist.

14. Detektor nach Anspruch 12 oder 13, **dadurch gekennzeichnet, dass** der Ausgang der Leitung mit einem Charge Coupled Device (CCD) verbunden ist.

15. Detektor nach einem der Ansprüche 12 bis 14, **dadurch gekennzeichnet, dass** der zweite Leiter mit einer Lokaloszillatorsignalquelle verbunden ist.

## Claims

1. A resistive mixer comprising
a line which includes a first (1) and a second (2) electrical conductor having a respective connecting contact (3, 4) so that an electrical high frequency signal can be coupled into the line,
wherein the first conductor (1) has a plurality of series-connected voltage-dependent resistor elements (FET1, FET2,..., FETN), and
wherein a capacitive element (C') is arranged between the first (1) and second (2) conductors.

2. A resistive mixer as set forth in claim 1 **characterised in that** the capacitive element is arranged between a first and a second voltage-dependent resistor element.

3. A resistive mixer as set forth in claim 1 or claim 2 **characterised in that** the voltage-dependent resistor elements and the capacitor element are integrated in a single semiconductor element on a single substrate.

4. A resistive mixer as set forth in one of claims 1 through 3 **characterised in that** the voltage-dependent resistor elements are field effect transistors each having a source (S), a drain (D), a gate (G) and a source-drain channel,
wherein the gates of all field effect transistors are so electrically connected together that the gates (G) form the second conductor and
wherein the drain of a first field effect transistor is connected to the source of a second field effect transistor so that the source, the source-drain channel and the drain of the first field effect transistor and the source, the source-drain channel and the drain of the second field effect transistor form the first conductor.

5. A resistive mixer as set forth in one of claims 1 through 4 **characterised in that** the individual field effect transistors are produced by structuring of the gate and/or the source-drain channel.

6. A resistive mixer as set forth in one of claims 1 through 5 **characterised in that** the capacitive element is produced by structuring of the gate and/or the source-drain channel.

7. A resistive mixer as set forth in one of claims 1 through 6 **characterised in that** each of the field effect transistors has an effective gate length of less than 250 nm, preferably less than 200 nm.

8. A resistive mixer as set forth in one of claims 1 through 7 **characterised in that** the second conductor is connected to a dc voltage source for biasing the gates of the field effect transistors.

9. A resistive mixer as set forth in one of claims 1 through 8 **characterised in that** the field effect transistors have negligibly low threshold voltages.

10. A resistive mixer as set forth in one of claims 1 through 9 **characterised in that** the first (1) and second (2) conductors are connected at their ends opposite to the connecting contacts (3, 4) to an external matching network.

11. A resistive mixer as set forth in one of claims 1 through 11 **characterised in that** the line has at least one further non-linear component, preferably a diode.

12. A detector for detecting electromagnetic high frequency radiation comprising a resistive mixer as set forth in one of claims 1 through 11.

13. A detector as set forth in claim 12 **characterised in that** the line is connected to an antenna element for high frequency radiation so that electromagnetic high frequency radiation received by the antenna in operation of the detector can be fed into the line.

14. A detector as set forth in claim 12 or claim 13 **characterised in that** the output of the line is connected to a charge coupled device (CCD).

15. A detector as set forth in one of claims 12 through 14 **characterised in that** the second line is connected to a local oscillator signal source.

## Revendications

1. Mélangeur résistif comprenant
une ligne, qui présente un premier conducteur (1) et un deuxième conducteur (2) électrique pourvus respectivement d'un contact de connexion (3, 4) de sorte qu'un signal haute fréquence électrique peut être injecté dans la ligne,
**caractérisé en ce que** le premier conducteur (1) présente une pluralité d'éléments de résistance (FET1, FET2, ..., FETN) dépendant de la tension branchés en série,
au moins un élément capacitif (C') étant disposé entre le premier conducteur (1) et le deuxième conducteur (2).

2. Mélangeur résistif selon la revendication 1, **caractérisé en ce que** l'élément capacitif est disposé entre un premier élément de résistance et un deuxième élément de résistance dépendant de la tension.

3. Mélangeur résistif selon la revendication 1 ou 2, **caractérisé en ce que** les éléments de résistance dépendants de la tension et l'élément capacitif sont intégrés dans un seul élément semi-conducteur sur un seul substrat.

4. Mélangeur résistif selon l'une quelconque des revendications 1 à 3, **caractérisé en ce que** les éléments de résistance dépendants de la tension sont des transistors à effet de champ pourvus respectivement d'une source (S), d'un drain (D), d'une grille (G) et d'un canal source-drain,
les grilles de tous les transistors à effet de champ étant connectées électriquement les unes aux autres de sorte que les grilles (G) constituent le deuxième conducteur (2), et
le drain d'un premier transistor à effet de champ étant connecté à la source d'un deuxième transistor à effet de champ de sorte que la source, le canal source-drain et le drain du premier transistor à effet de champ et la source, le canal source-drain et le drain du deuxième transistor à effet de champ constituent le premier conducteur (1).

5. Mélangeur résistif selon l'une quelconque des revendications 1 à 4, **caractérisé en ce que** les divers transistors à effet de champ sont réalisés par une structuration de la grille et/ou du canal source-drain.

6. Mélangeur résistif selon l'une quelconque des revendications 1 à 5, **caractérisé en ce que** l'élément capacitif est réalisé par une structuration de la grille et/ou du canal source-drain.

7. Mélangeur résistif selon l'une quelconque des revendications 1 à 6, **caractérisé en ce que** chaque transistor à effet de champ présente une longueur effective de grille inférieure à 250 nm, de préférence inférieure à 200 nm.

8. Mélangeur résistif selon l'une quelconque des revendications 1 à 7, **caractérisé en ce que** le deuxième conducteur (2) est connecté à une source de tension continue servant à précontraindre les grilles des transistors à effet de champ.

9. Mélangeur résistif selon l'une quelconque des revendications 1 à 8, **caractérisé en ce que** les transistors à effet de champ présentent de faibles tensions de seuil de façon négligeable.

10. Mélangeur résistif selon l'une quelconque des revendications 1 à 9, **caractérisé en ce que** le premier conducteur (1) et le deuxième conducteur (2) sont connectés, par leurs extrémités faisant face aux contacts de connexion (3, 4), à un réseau d'adaptation externe.

11. Mélangeur résistif selon l'une quelconque des revendications 1 à 11, **caractérisé en ce que** la ligne présente au moins un autre composant non linéaire, de préférence une diode.

12. Détecteur servant à détecter un rayonnement électromagnétique à haute fréquence, équipé d'un mélangeur résistif selon l'une quelconque des revendications 1 à 11.

13. Détecteur selon la revendication 12, **caractérisé en ce que** la ligne est connectée à un élément antenne pour rayonnement à haute fréquence, de sorte que, lorsque le détecteur fonctionne, le rayonnement électromagnétique à haute fréquence reçu par l'antenne peut être injecté dans la ligne.

14. Détecteur selon la revendication 12 ou 13, **caractérisé en ce que** la sortie de la ligne est connectée à un dispositif à couplage de charge (CCD).

15. Détecteur selon l'une quelconque des revendications 12 à 14, **caractérisé en ce que** le deuxième conducteur est connecté à une source de signaux d'oscillateur local.
